# EUROPEAN PATENT APPLICATION

(11) **EP 4 108 813 A1**
(43) Date of publication of application: **28.12.2022**
(21) Application number: 20931372.5
(22) Date of filing: 25.09.2020
(51) Int. Cl.: C30B 33/06, C30B 33/00

(54) **HOT ISOSTATIC PRESSING BONDING METHOD FOR HIGH-PURITY SEMICONDUCTOR SINGLE CRYSTAL**

(30) Priority: 17.04.2020 CN 202010305336
(71) Applicant: The 13th Research Institute Of China Electronics Technology Group Corporation, Shijiazhuang, Hebei 050051 (CN); China Nanhu Academy of Electronics and Information Technology, Jiaxing, Zhejiang 314000 (CN)
(72) Inventor: WANG, Shujie, Shijiazhuang, Hebei 050051 (CN); SUN, Niefeng, Shijiazhuang, Hebei 050051 (CN); SUN, Tongnian, Shijiazhuang, Hebei 050051 (CN); LIU, Huisheng, Shijiazhuang, Hebei 050051 (CN); XU, Senfeng, Shijiazhuang, Hebei 050051 (CN)
(74) Representative: Sun, Yiming
(86) International application number: PCT/CN2020/117591
(87) International publication number: WO 2021/208364

(57) **Abstract**

A hot isostatic pressing joining method for a high-purity semiconductor monocrystal falls within the field of semiconductor material preparation, particularly relating to a method for preparing a large-size monocrystal by solid-state joining between a plurality of small-size monocrystals via hot isostatic pressing. comprising the steps of: selecting semiconductor monocrystal blocks with generally similar physical properties and basically the same crystal orientation accuracy of the splicing plane; subjecting the splicing plane of the semiconductor monocrystal block to orientation, polishing and acid washing treatments; abutting the splicing planes of the processed monocrystal blocks to assembly into one body; and placing the assembled monocrystal blocks in a hot isostatic pressing furnace body for heating and pressure treatments to complete solid-state joining between the monocrystal blocks. It has the following advantageous effects: 1, the small-sized monocrystal blocks can be joined to prepare a large-size monocrystal; 2, the equipment is simple; 3, in the preparation process, there is no need to consider the problems that need to be paid attention to in the traditional monocrystal growth process, such as dislocation, twinning and polycrystallization; and 4, a monocrystal of any size can be prepared theoretically.

## Description

### Technical Field

The present invention falls within the field of semiconductor material preparation, and particularly relates to a method for preparing a large-size monocrystal by solid-state joining between a plurality of small-size monocrystals via hot isostatic pressing.

### Background Art

Compound semiconductor materials, as one of the important basic supporting technologies for the development of the electronic information industry technology system, are widely used in optical fiber communication, mobile communication, navigation, detection and other fields. They have become a hot spot for the development of various countries. Compound semiconductor monocrystal substrate is the basis for the preparation of various types of electronic devices. The larger the size of semiconductor monocrystal, the lower the cost of the prepared devices. The size of semiconductor monocrystal substrate reflects the competitiveness of the development of the semiconductor industry in a country.

However, the larger the size of the semiconductor monocrystal substrate, the more difficult it is to prepare using conventional methods: larger size of monocrystal furnace equipment, higher requirements for stability and symmetry of monocrystal growth temperature field, and higher instrument requirements for the equipment. At the same time, the size of the crucible will increase accordingly. In order to establish a temperature gradient, the temperature of the crucible edge will become higher and higher, which would reduce the strength of the crucible. Even worse, the crucible cannot withstand high temperatures and contaminates the melt. At the same time, the utilization of energy will be reduced accordingly. Therefore, from the point of view of equipment and consumables, more and more problems are encountered only by enlarging the furnace body, increasing the size of the insulation and heating device, the size of the crucible and the size of the furnace body without limit.

Micro defects such as dislocations and inclusions can seriously affect the quality and yield of subsequent devices. Twinning and polycrystallization in compound semiconductors are unacceptable macro defects. Dislocations and twinning/polycrystallization are contradictory. The reduction of dislocations requires a reduction of the temperature gradient, but the reduction of the temperature gradient increases the chance of twinning and the formation of polycrystallization. Therefore, from the perspective of growth, it is more and more difficult to prepare large-size monocrystals with high-quality and low defects.

Chinese patent application CN 110541199 A discloses a method for preparing a high-quality SiC seed crystal with a diameter of 8 inches and above, comprising: cutting and splicing a SiC wafer or crystal with a size smaller than a target seed crystal; processing the spliced SiC seed crystal into a complete wafer shape by using an external grinding machine; performing lateral epitaxial growth on a growth surface of the spliced SiC seed crystal to fill a splicing crack of the seed crystal; performing homoepitaxy at the growth surface of the seed crystal to obtain a high-quality SiC seed crystal with a diameter of 8 inches and above, small total surface thickness variation, no cracks, and low defect density. This application represents a technical idea of joining them together by epitaxial growth.

In this way, it is necessary to control the reductive growth environment and join them together by epitaxial growth. Epitaxial growth requires epitaxial gases to be deposited at the joint by physical chemistry.

By means of hot isostatic pressing, the growth environment is basically controlled to complete the crystal growth at present, e.g., Chinese patent application 201210003909.3 (a high temperature and high pressure crystal growth equipment), and Chinese patent application 201910263191.3 (a hot isostatic pressing device suitable for the generation of gallium nitride monocrystal product by ammonothermal method).

### Summary of the Invention

The present invention provides a new idea to prepare a large-size high-purity semiconductor monocrystal by solid-state joining of a plurality of small-sized monocrystals by a hot isostatic pressing joining method.

In order to achieve the above-mentioned object, the technical solution adopted by the present invention is a hot isostatic pressing joining method for a high-purity semiconductor monocrystal, comprising the following steps:
material selection: selecting semiconductor monocrystal blocks with generally similar physical properties and basically the same crystal orientation accuracy of the splicing plane;
splicing plane processing: subjecting the splicing plane of the semiconductor monocrystal block to orientation, polishing and acid washing treatments;
monocrystal assembling: abutting the splicing planes of the processed monocrystal blocks to assembly into one body; and
monocrystal joining: placing the assembled monocrystal blocks in a hot isostatic pressing furnace body for heating and pressure treatments to complete solid-state joining between the monocrystal blocks.

Further, the splicing plane has a roughness of 0.3 nm to 10 nm, a flatness of 1 to 10 microns, and a crystal orientation difference between the splicing planes of less than 0.05°.

Further, the semiconductor crystal block is obtained by cutting a single ingot or a plurality of ingots.

The implementation principle of the present invention is: the assembled monocrystal blocks are subjected to hot isostatic pressing; at a certain pressure and temperature, according to the consistency of crystal lattice, atom bonding and connection are realized at the splicing plane between the monocrystal blocks at high temperature and high pressure through a long time of solid-state atom diffusion; and all the monocrystal blocks are joined in solid-state to form a large monocrystal.

It has the following advantageous effects: 1, the small-sized monocrystal blocks can be joined to prepare a large-size monocrystal; 2, the equipment is simple; 3, in the preparation process, there is no need to consider the problems that need to be paid attention to in the traditional monocrystal growth process, such as dislocation, twinning and polycrystallization; and 4, a monocrystal of any size can be prepared theoretically.

### Brief Description of the Drawings

Fig. 1 is an assembly diagram of joining monocrystals by hot isostatic pressing;
Fig. 2 is an assembly diagram of splicing crystals;
Fig. 3 is an assembly schematic diagram of precision splicing of a plurality of monocrystals;
Fig. 4 is a schematic diagram of an ingot and a planned position for cutting a crystal rod;
Fig. 5 is a schematic diagram of cutting monocrystal blocks from a crystal rod having twins and polycrystals;
Fig. 6 shows the splicing and combination of monocrystal blocks cut from the same ingot;
Fig. 7 is a schematic diagram of cutting monocrystal blocks from different ingots and splicing the monocrystal blocks; and
Fig. 8 is a schematic diagram of cutting monocrystal blocks from different ingots.

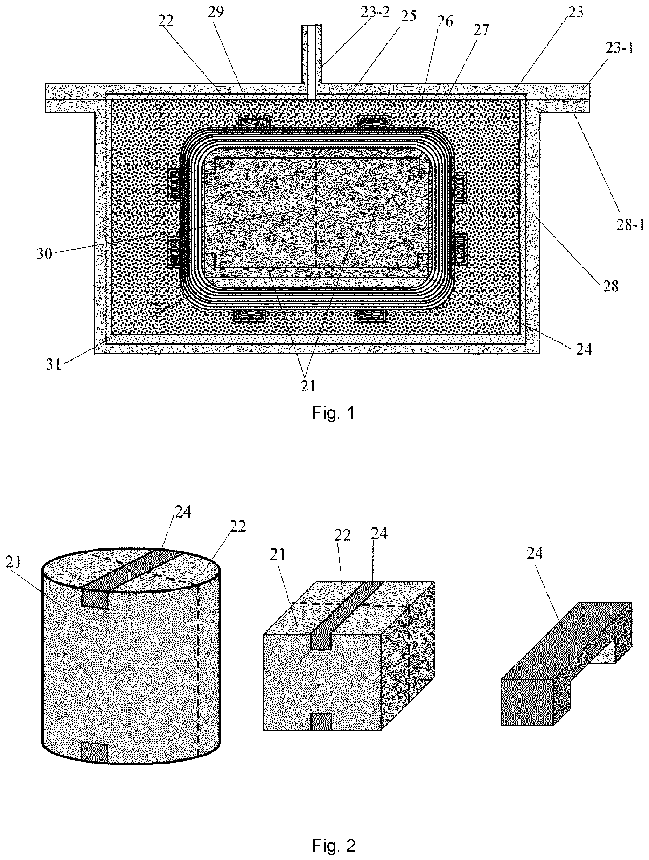

Wherein: in Figs. 1-3, 21: monocrystal block; 22: fastening collar; 23: jacket upper cover; 23-1: jacket upper cover sealing edge; 23-2: evacuation hole; 24: fixture; 25: quartz wrapping layer; 26: semiconductor powder layer; 27: jacket protection layer; 28: jacket body; 28-1: jacket body sealing edge; 29: fastening collar protection layer; 30: splicing plane; 31: substrate; and 32: filling block.

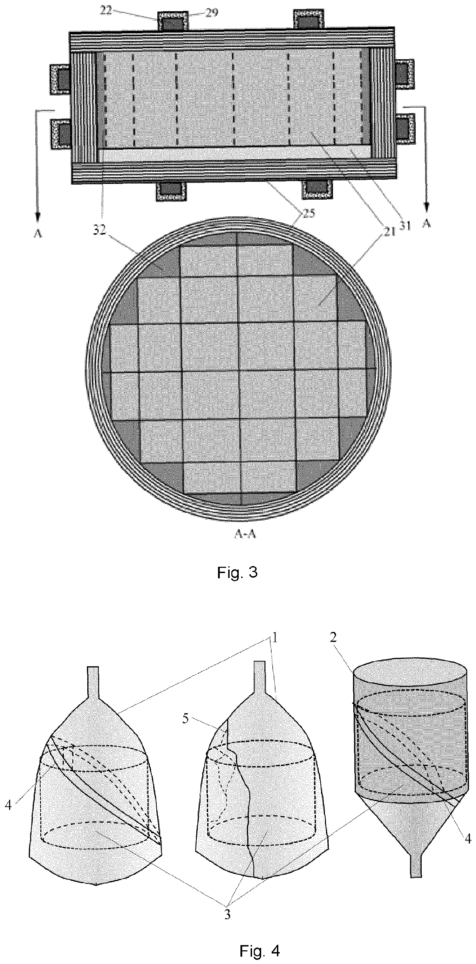

In Fig. 4, 1: LEC ingot; 2: VGF ingot; 3: crystal rod; 4: twin crystal boundary; and 5: polycrystal boundary.

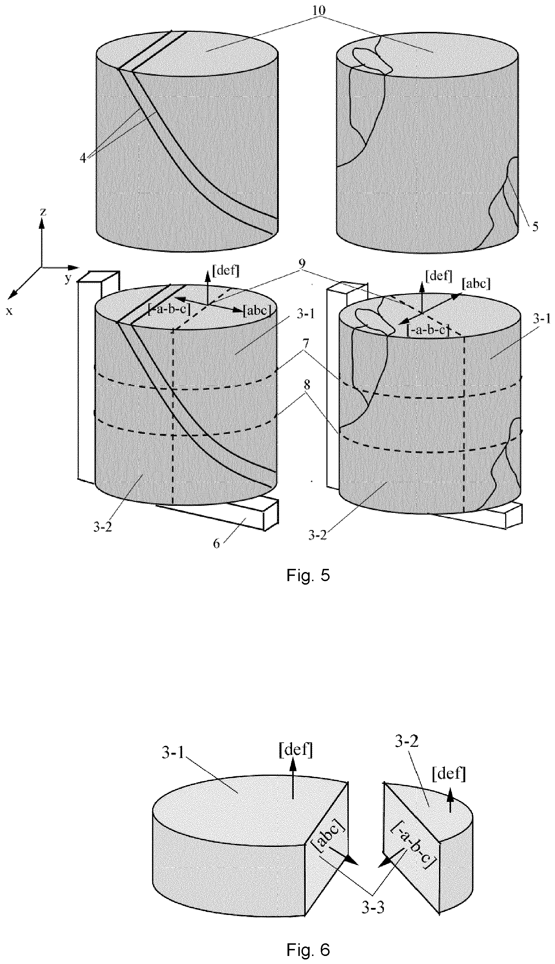

In Fig. 5, 4: twin crystal boundary; 5: polycrystal boundary; 6: binding resin; 7: cutting line trajectory I; 8: cutting line trajectory II; 9: cutting line trajectory III; 10: reference plane; 3-1: monocrystal block I; and 3-2: monocrystal block II.

In Fig. 6, 3-3: splicing plane I.

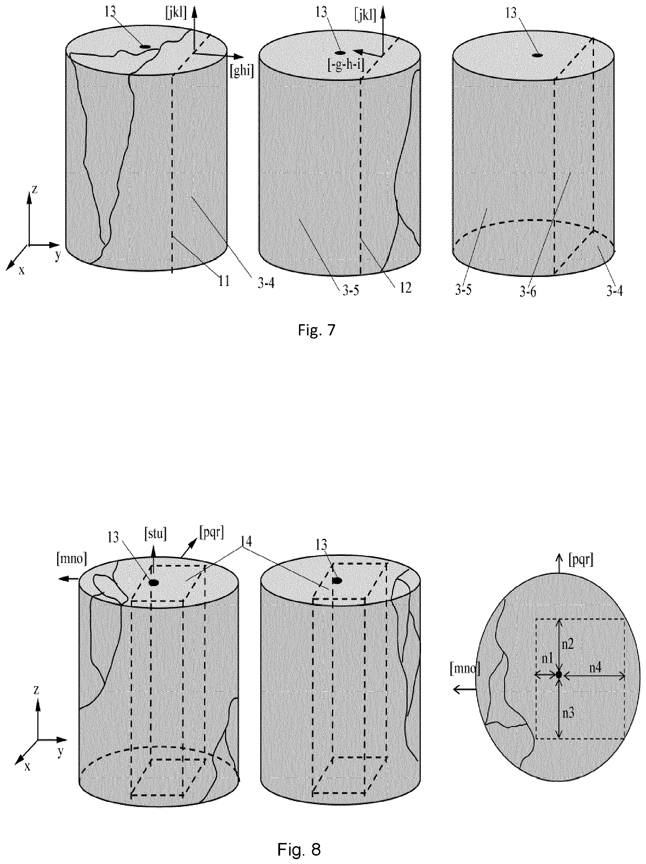

In Fig. 7, 11: cutting trajectory IV; 12: cutting trajectory V; 13: center of ingot/crystal rod; 3-4: monocrystal block III; 3-5: monocrystal block IV; and 3-6: splicing plane II.

In Fig. 8, 14: monocrystal block VI.

### Detailed Description of the Invention

Preparing a large-size monocrystal of the present invention is completed by the following steps.

### I. material selection: selecting semiconductor monocrystal blocks with generally similar physical properties and basically the same crystal orientation accuracy of the splicing plane.

The "generally similar physical properties" means that the thermal field of crystal growth and growth conditions are the same, and the concentration of dopants in the melt and the crystal shape are similar.

The monocrystal block is free of defects such as twins and polycrystals.

Suitable monocrystal blocks may be selected from monocrystals that have been cut.

The present invention provides a method of obtaining a monocrystal block by cutting directly from an ingot.

Three ingots are shown in Fig. 4: two LEC ingots 1, and one VGF ingots 2. The ingots have twin and polycrystalline macro defects, and twin crystal boundary 4 and polycrystal boundary 5 represent the positions of the defects. Defects also exist in the crystal rod 3 cut from the ingot.

1. A semiconductor crystal block can be obtained by cutting a single ingot, as shown in Fig. 5. In the figure, the cylinders are crystal rods 3 (not shown) and the left and right parts represent crystal rods with two different macroscopic (twin or polycrystalline) defects at different locations.

The overall physical properties of one ingot are the same. Since the cutting plane is the splicing plane, it can ensure that the splicing planes of the two monocrystal blocks have the same crystal orientation and high splicing accuracy.

When cutting, it is necessary to ensure that the interior of the cut monocrystal block is free from macroscopic defects, and at the same time, it is necessary to consider the utilization rate of materials.

The cutting method comprises:
A1, cutting the ingot 1 or 2 into the cylindrical crystal rod 3, bonding the crystal rod 3 on a resin block 6, machining a reference plane 10, and setting a coordinate system based on the reference plane 10;
A2, setting a cutting line trajectory I 7, a cutting line trajectory II 8 and a cutting line trajectory III 9;
   wherein the crystal rod 3 is observe by naked eyes or an instrument; when setting the cutting trajectory, it is necessary to ensure that the two monocrystal blocks 3-1 and 3-2 are cut to avoid twin crystal boundary 4 or polycrystal boundary 5, and at the same time try to make the heights of the two monocrystal blocks the same;
A3, cutting the crystal rod 3 along the cutting line trajectory I 7 and the cutting line trajectory II 8; and
A4, cutting the crystal rod 3 along the cutting line trajectory III 9;
   wherein the machining does not cut through the resin block 6; the crystal rod 3 and the resin block can be in an integral state, and then the resin block 6 is removed by boiling with water;
   through the above steps, monocrystal bulk I 3-1 and monocrystal bulk II 3-2 can be obtained. Steps A3 and A4 are in no particular order.

Since the crystal rod 3 is cut along the cutting line trajectory III 9, the monocrystal block I 3-1 and the monocrystal block II 3-2 can be spliced into a whole circle. In order to obtain a highly uniform monocrystal block, another monocrystal block may be machined according to the height of the thinner monocrystal block.

The monocrystal block I 3-1 and the monocrystal block II 3-2 are spliced through the splicing plane 3-3 to keep two crystals have the same [def] crystal orientation.

### 2. A semiconductor crystal block can be obtained by cutting a plurality of ingotss.

The present invention provides two methods.

Method 1 comprises: cutting two monocrystal blocks from two ingots and combining into a cylinder, as shown in Fig. 7.

The ingot with the same thermal field of crystal growth and growth conditions, similar dopant concentration and crystal shape in the melt are chosen.

During cutting, it is necessary to ensure that the interior of the cut monocrystal block is free from macroscopic defects, and the crystal direction accuracy of the splicing plane is basically consistent. The utilization rate of materials should also be considered.

The cutting method comprises:
B1, cutting cylindrical crystal rods 3 with the same diameter on two different ingots 1 or 2 respectively, and machining reference planes 10 respectively, the crystal orientation indexes of the two crystal rods 3 being the same;
B2, setting a cutting line trajectory IV 11 on one of the crystal rods 3, and cutting the crystal rod 3 along the cutting line trajectory IV 11 to obtain a monocrystal block III 3-4;
B3, testing the crystal orientation index [ghi] of the cut crystal plane on the monocrystal block III 3-4, and measuring a distance d from a center of a circle 13 of the reference plane 10 to the cutting line trajectory IV 11; and
B4, selecting a [-g-h-i] crystal plane on another crystal rod, designing the cutting line trajectory IV 11 at a position where the distance from the center 13 of the circle to the crystal plane is d, and cutting along the cutting line trajectory IV 11 to obtain monocrystal blocks IV 3-5.

When the bulk crystal rods 3 are cut, the heights of the two crystal rods 3 are made uniform as much as possible.

The crystal rod 3 is observe by naked eyes or the instrument; when setting the cutting trajectory, it is necessary to ensure that the two monocrystal blocks 3-5 and 3-6 are cut to avoid the defect area represented by the curves in the figure.

The orientation indexes of the two crystal rods 3 are kept the same by orientation (measure crystal orientation) [jkh]).

Since the crystal rod 3 is cut along the cutting line trajectory IV 11, the monocrystal block I 3-4 and the monocrystal block II3-5 can be spliced into a cylinder. In order to obtain a highly uniform monocrystal block, another monocrystal block may be machined according to the height of the monocrystal block with a lower height.

Method 2 comprises: cutting a plurality of monocrystal blocks from a plurality of ingots, and combining the monocrystal blocks into a cuboid or cube, as shown in Fig. 8.

The ingot with the same thermal field of crystal growth and growth conditions, similar dopant concentration and crystal shape in the melt are chosen.

During cutting, it is necessary to ensure that the interior of the cut monocrystal block is free from macroscopic defects, and the crystal direction accuracy of the splicing plane is basically consistent. The utilization rate of materials should also be considered.

The cutting method comprises:
C1, cutting cylindrical crystal rods 3 with the same diameter on different ingots 1 respectively, machining reference planes 10 respectively, and setting a coordinate system based on the reference plane 10, the crystal orientation index of each crystal rod 3 being the same; and
C2, cutting monocrystal blocks VI 14 from different crystal rods 3, the [mno] and [pqr] crystal orientations of all the monocrystal blocks being consistent, and the distances nI, n2, n3 and n4 of each face of each monocrystal block VI 14 from the center 13 of the circle of the reference plane of the crystal rod 3 being the same.
Step C2 can ensure a consistent cutting position on the crystal rod 3.

### II. splicing plane processing: subjecting the splicing plane of the semiconductor monocrystal block to orientation, polishing and acid washing treatments.

The crystal blocks cut by the above method do not need to be oriented.

For the crystal block not selected by the above method, the monocrystal is oriented by measuring the crystal orientation.

For the selected crystal block or the cut crystal block, the splicing plane thereof is subjected to polishing and pickling treatment, so that the splicing plane has a roughness of 0.3nm-10nm, a flatness of 1-10 microns, and a difference in crystal orientation between the splicing planes of less than 0.05°.

### III. monocrystal assembling: abutting the splicing planes of the processed monocrystal blocks to assembly into one body.

As shown in Fig. 6, the monocrystal block I 3-1 and the monocrystal block II 3-2 are spliced through the splicing plane 3-3 to keep two crystals have the same [def] crystal orientation. In the rightmost drawing of Fig. 7, the monocrystal blocks III 3-4 and IV 3-5 can be spliced through the splicing plane II 3-6, so that the electrical uniformity and symmetry of the monocrystal substrate processed after the whole spliced crystal rod is joined can be ensured.

The monocrystal blocks cut in Fig. 8 can be spliced as shown in the middle graph of Fig. 2 or Fig. 3. When splicing monocrystal blocks, it is necessary to ensure that the [mno] crystal orientation is joined to the splicing plane of the [-m-n-o] crystal orientation of another monocrystal block, and the [pqr] crystal orientation is joined to the splicing plane of the [-p-q-r] crystal orientation of another monocrystal block. More monocrystal blocks can be joined. The splicing method can ensure the uniformity distribution between the wafers to be continuous.

In order to facilitate processing in a hot isostatic pressing furnace, in the present embodiment, an assembly structure is used to complete monocrystal assembly as follows:
1: processing monocrystal block 21 and a splicing plane 30 thereof, wherein the splicing planes 30 of two monocrystal blocks 21 joined to each other is a common crystal plane of the two monocrystal blocks 21, and keeping two different crystal orientations randomly taken on the crystal planes to be basically consistent (the difference in crystal orientation being less than 0.05°) to realize that the periodicity of the overall crystal lattice arrangement on the different monocrystal blocks is approximately consistent.

The splicing plane 30 is mechanically and chemically polished, and the surface roughness of the splicing plane 30 is 0.3 nm to 10 nm, and the flatness is 1 to10 microns.

If a fixture 24 is needed to fix, a clamping groove is machined on the monocrystal block 21, and a fixture 24 is machined, the size of the fixture 24 being determined according to the combined size of a plurality of monocrystal blocks 21.

The fixture 24 is cut using a semiconductor material of the same material as the crystal block 1, and is assembled in cooperation with the monocrystal block 21, so as to prevent stress defects caused by different thermal expansion coefficients of different materials.

The position of the machined clamping groove should ensure that the direction of the fixture 24 is perpendicular to the direction of the splicing plane 30, so as to ensure that the direction of the force exerted by the fixture 24 is perpendicular to the splicing plane 30.

The fixture 24 is used to join the monocrystal blocks 21 together, as shown in Fig. 2. The fixtures 24 are respectively provided at upper and lower positions of the combination of the monocrystal blocks 21, so as to ensure the accuracy of joining and ensure that the splicing plane 30 is not easy to move relatively under the hot isostatic pressing.

Fig. 2 is a schematic diagram of splicing two monocrystal blocks 21 together.

Fig. 3 is a schematic diagram of splicing a plurality of monocrystal blocks 21 together of another example. In the example of Fig. 3, filling blocks 32 are used to fill the periphery of the outermost monocrystal block 21 so that the overall shape is suitable for wrapping. The filling block 32 is cut from the same semiconductor material as the crystal block 21.

In order to ensure that the monocrystal block 21 is not dislocated during the wrapping process, after the combination is fixed, a substrate 31 is provided below the combination of the fixed monocrystal block 21. The substrate 31 uses a semiconductor material of the same material as the crystal block 1 and can be a monocrystal or a polycrystalline material.

The quartz cloth or quartz fiber wires are washed with organic solvent, and subjected to high temperature vacuum treatment high-temperature vacuum treatment, to remove the oil stain on the surface. At the same time, the quartz wires easy to fall off are removed by vibration and purging. The effect is to prevent contamination and to prevent the splicing plane from entering liquids and other impurities.

The assembled fixed monocrystal block 21 is tightly coated with a quartz wrapping layer 25.

A fastening collar 22 is used for fastening after the wrapping is completed. A fastening collar protection layer 29 is provided outside the fastening collar 22. The surface of the fastening collar 22 is provided with a boron oxide coating with a thickness of 0.5 to1 mm. The boron oxide coating can prevent metal from contaminating the semiconductor material.

Upon completion of the above assembly, a crystal block unit is obtained.

The semiconductor powder layer 26 is formed by placing the crystal block unit into a jacket body 28 and filling the surrounding with a homogenous semiconductor material powder as the monocrystal block 21. The crystal block unit should be located at the center of the jacket body 28 (not required to be precise, but about in the center), and the semiconductor powder is compacted, as shown in Fig. 1.

In Fig. 1, the jacket protection layer 27 is a boron oxide coating with a thickness of 0.5-1mm. There is no boron oxide coating at a jacket upper cover sealing edge 23-1 and a jacket body sealing edge 28-1.

The assembly of the structure is accomplished by laser or electron beam welding of the jacket upper cover sealing edge 23-1 and the jacket body sealing edge 28-1.

### IV. Pre-treatment: after the monocrystal assembly is completed, the whole jacket is vacuumed to 10⁻³ to 10⁻⁶ Pa through an evacuation hole (23-2) and preheated at a temperature of 400°C for 0.5 to 5 hours.

The main function of the heat treatment is to remove the oxide layer from the crystal surface.

After the pretreatment is completed, the evacuation holes 23-2 are pressed, and then laser or electron beam welding is performed to seal the evacuation holes 23-2 for leak detection.

### V. Monocrystal joining: placing the assembled and pretreated monocrystal blocks in a hot isostatic pressing furnace body for heating and pressure treatments to complete solid-state joining between the monocrystal blocks.

The temperature of the hot isostatic pressing is set as 0.8 to 0.9 Tm. After reaching the set hot isostatic pressing temperature, a protective gas is filled into the hot isostatic pressing furnace body. The pressure is slowly raised to 20 MPa to 300 MPa. Different pressures can be selected according to different semiconductor materials.

Although the splicing planes are treated, it is not excluded that there are minute protrusions on the splicing planes. When pressure is applied at low temperature, the local part (convex part) on the splicing plane will endure great pressure. If the pressure exceeds the maximum strength at low temperature, the crystal will be fractured locally, and defects will occur after treatments.

In addition, the boron oxide material is relatively brittle at low temperatures. If pressure is applied at low temperatures, the pressure may cause deformation of the hot isostatic pressing jacket, causing the boron oxide layer to break, fall off or move, exposing the metal layer of the jacket body 28 or jacket upper cover 23, causing metal atoms to diffuse and contaminate the semiconductor material.

After the treatment is completed, the protective gas is discharged, the temperature is slowly lowered to room temperature. The metal jacket is removed by wire cutting. Then, a semiconductor polycrystalline region formed by the semiconductor powder layer 26 under high pressure, the quartz wrapping layer 25, the fixture 24, the filling blocks 32 and the homogenous semiconductor substrate 31 are cut by a wire saw to obtain a large-size crystal block by joining.

In order to reduce the influence of local thermal stress on the semiconductor crystal, the welding position of the jacket upper cover sealing edge 23-1 and the jacket body sealing edge 28-1 is far away from the jacket body 28 as far as possible, and the weld seam position of the evacuation hole 23-2 is at least 5 mm away from the hot isostatic pressing body 28.

During the entire hot isostatic pressing process, positions are maintained properly: the assembly structure is always placed in the hot isostatic pressing furnace with the orientation of the single crystal block 1 above the homogenous semiconductor substrate 11.

## Claims

1. A hot isostatic pressing joining method of a high-purity semiconductor monocrystal, **characterized by** comprising the steps of:
material selection: selecting semiconductor monocrystal blocks with generally similar physical properties and basically the same crystal orientation accuracy of the splicing plane;
splicing plane processing: subjecting the splicing plane of the semiconductor monocrystal block to orientation, polishing and acid washing treatments;
monocrystal assembling: abutting the splicing planes of the processed monocrystal blocks to assembly into one body; and
monocrystal joining: placing the assembled monocrystal blocks in a hot isostatic pressing furnace body for heating and pressure treatments to complete solid-state joining between the monocrystal blocks.

2. The method of claim 1, **characterized in that**, the splicing plane has a roughness of 0.3 nm to 10 nm, a flatness of 1 to 10 microns, and a crystal orientation difference between the splicing planes of less than 0.05°.

3. The method of claim 1, **characterized in that**, a semiconductor crystal block is obtained by cutting a single ingot, the cutting method comprising:
A1, cutting the ingot (1) into a cylindrical crystal rod (3), machining a reference plane (10), and setting a coordinate system based on the reference plane (10);
A2, setting a cutting line trajectory I (7), a cutting line trajectory II (8) and a cutting line trajectory III (9);
A3, cutting the crystal rod (3) along the cutting line trajectory I (7) and the cutting line trajectory II (8); and
A4, cutting the crystal rod (3) along the cutting line trajectory III (9) to obtain a monocrystal block I (3-1) and a monocrystal block II (3-2).

4. The method of claim 1, **characterized in that**, a semiconductor crystal block is obtained by cutting a plurality of ingots, the cutting method comprising:
B1, cutting cylindrical crystal rods (3) with the same diameter from two different ingots (1) respectively, machining reference planes (10) respectively, and maintaining crystal orientation indexes of the two crystal rods (3) to be the same by orientation;
B2, setting a cutting line trajectory IV (11) on one of the crystal rods (3), and cutting the crystal rod (3) along the cutting line trajectory IV (11) to obtain a monocrystal block III (3-4);
B3, testing the crystal orientation index [ghi] of the cut crystal plane on the monocrystal block III (3-4), and measuring a distance d from a center of a circle (13) of the reference plane (10) to the cutting line trajectory IV (11); and
B4, selecting a [-g-h-i] crystal plane on another crystal rod, designing the cutting line trajectory IV (11) at a position where the distance from the center of a circle (13) to the crystal plane is d, and cutting along the cutting line trajectory IV (11) to obtain monocrystal blocks IV (3-5).

5. The method of claim 1, **characterized in that**, a semiconductor crystal block is obtained by cutting a plurality of ingots, the cutting method comprising:
C1, cutting cylindrical crystal rods (3) with the same diameter from different ingots (1) respectively, and machining reference planes (10) respectively, the crystal orientation index of each ingot (3) being the same; and
C2, cutting monocrystal blocks VI (14) from different crystal rods (3), the [mno] and [pqr] crystal orientations of all the monocrystal blocks being consistent, and the distances nI, n2, n3 and n4 of each face of each monocrystal block VI (14) from the center of a circle (13) of the reference plane of the crystal rod (3) being the same.

6. The method of claim 1, **characterized in that**, monocrystal assembly is completed by using an assembly structure comprising a jacket and a crystal block unit disposed inside the jacket, the jacket consisting of a jacket body (28) and a jacket upper cover (23),
wherein an evacuation hole (23-2) is provided on the jacket body (28) or the jacket upper cover (23), and a jacket protection layer (27) is provided on inner surfaces of the jacket body (28) and the jacket upper cover (23);
wherein the crystal block unit comprises a plurality of monocrystal blocks (21); the monocrystal blocks (21) are combined via a splicing plane (30) and fixed using a fixture (24); and a combined outer surface of the fixed monocrystal blocks (21) is provided with a quartz wrapping layer (25); and
the fixture (24) uses the same semiconductor material as the crystal block (21).

7. The method of claim 6, **characterized in that**, the crystal block unit is placed in the center of the jacket body (28), and the surrounding area is filled with a homogenous semiconductor material powder as the monocrystal block (21).

8. The method of claim 7, **characterized in that**, the particle size of the semiconductor powder is larger than the flatness of the splicing plane.

9. The method of claim 7, **characterized in that**, after the monocrystal assembly is completed, the whole jacket is vacuumed to 10⁻³ to 10⁻⁶ Pa through an evacuation hole (23-2) and preheated at a temperature of 400°C for 0.5 to 5 hours; and the evacuation hole (23-2) is sealed.

10. The method of claim 9, **characterized in that**,
monocrystal joining: placing the assembled monocrystal block in a hot isostatic pressing furnace body for heating and pressure treatments, wherein the temperature of the hot isostatic pressing is 0.8 to 0.9 Tm; when the set temperature is reached, charging a protective gas into the hot isostatic pressing furnace body, slowly increasing the pressure to 20 MPa to 300 MPa, and then maintaining same for 30 min-10 hours;
wherein Tm is the melting point of the joined semiconductor material.
